# EUROPEAN PATENT APPLICATION

(11) **EP 2 369 317 A1**
(43) Date of publication of application: **28.09.2011**
(21) Application number: 11159394.3
(22) Date of filing: 23.03.2011
(51) Int. Cl.: G01L 25/00

(54) **Torque detector and electric power steering system**

(30) Priority: 25.03.2010 JP 2010070203
(71) Applicant: JTEKT CORPORATION, Osaka-shi Osaka 542-8502 (JP)
(72) Inventor: AOKI, Kaname, Osaka-shi, Osaka 542-8502 (JP); HOTTA, Kensaku, Osaka-shi, Osaka 542-8502 (JP)
(74) Representative: TBK

(57) **Abstract**

A torque detector (17) includes a sensor unit (22) including a single magnetic sensor (35) capable of detecting a change of flux, a torque detecting unit (23) that detects torque based on an output of the sensor unit (22), and a magnetic field generator (24) capable of generating a magnetic field in an area including the sensor unit (22). The torque detecting unit (23) has a failure detecting mode that detects an abnormality of the sensor unit (22) based on an offset amount of the output of the sensor unit (22). The offset amount is obtained when the magnetic field is generated by the magnetic field generator (24).

## Description

### BACKGROUND OF THE INVENTION

### Field of the Invention

This invention relates to a torque detector and an electric power steering system.

### Description of Related Arts

Atorque detector for use in, for example, anelectric power steering system (EPS) is usually structured to detect the torsional angle of a torsion bar and calculate the input torque to its rotational axis.

As a related art, a torque detector includes a Hall IC or the like, that outputs a signal whose output level (an output voltage) is changed in accordance with the torsional angle of a torsion bar, i.e., in accordance with the input torque (see Japanese Published Patent Application No. 2005-300267, for example).

This type of torque detector has a multiple structure using two Hall ICs, and therefore the reliability of this detector is improved. In other words, a failure of each Hall IC is detected based on a comparison between outputs of two Hall ICs, and therefore the reliability of this is improved.

However, because two Hall ICs are used, production costs rise.

### SUMMARY OF THE INVENTION

It is an object of the present invention to provide a torque detector and an electric power steering system that are low-cost products and that have high reliability with respect to the detection of failures.

In an aspect of the present invention, the torque detector includes a sensor unit including a single magnetic sensor capable of detecting a change of magnetic flux, a torque detecting unit that detects torque based on an output value of the sensor unit, and a magnetic field generator capable of generating a magnetic field in an area including the sensor unit. The torque detecting unit has a failure detecting mode that detects an abnormality of the sensor unit based on an offset amount of the output value of the sensor unit. The offset amount is obtained when the magnetic field is generated by the magnetic field generator.

### BRIEF DESCRIPTION OF THE DRAWINGS

FIG. 1 is a schematic view showing a general structure of an electric power steering system that includes a torque detector according to a first embodiment of the present invention.
FIG. 2 is an exploded perspective view of the torque detector.
FIG. 3 is a schematic view showing a structure of the torque detector.
FIG. 4 is a flowchart showing a flow of the control of failure detection.
FIG. 5 is a view showing a change in output of a Hall IC caused when a magnetic field generator is turned on/off during non-traveling and non-steering.
FIG. 6 is a view showing a change in output of the Hall IC caused when the magnetic field generator is turned on/off during traveling and steering.
FIG. 7 is a view showing a change with a time lapse of torque detected when the magnetic field generator is turned on/off.
FIG. 8 is a schematic view showing a structure of a torque detector according to a second embodiment of the present invention.
FIG. 9 is a view showing a change with a time lapse of the differential value of a Hall-IC output in the embodiment of FIG. 8.
FIG. 10 is a flowchart showing a flow that sets a cycle of the execution of a differential-value-failure detecting mode of a Hall-IC output in the embodiment of FIG. 8.
FIG. 11 is a view showing a change with a time lapse of steering torque detected in a third embodiment of the present invention.
FIG. 12 is a flowchart showing a flow that sets a cycle of the execution of a failure detecting mode based on steering torque detected in the embodiment of FIG. 11.
FIG. 13 is a block diagram of a main part of an electric structure according to a fourth embodiment of the present invention.
FIG. 14 is a block diagram of a main part of an electric structure according to a fifth embodiment of the present invention.

### DETAILED DESCRIPTION OF THE PREFERRED EMBODIMENTS

Preferred embodiments of the present invention will be described with reference to the accompanying drawings. Although these embodiments are described based on an example in which a torque detector is applied to an electric power steering system of a vehicle, the torque detector of the present invention can also be applied to other devices or other equipment except the electric power steering system.

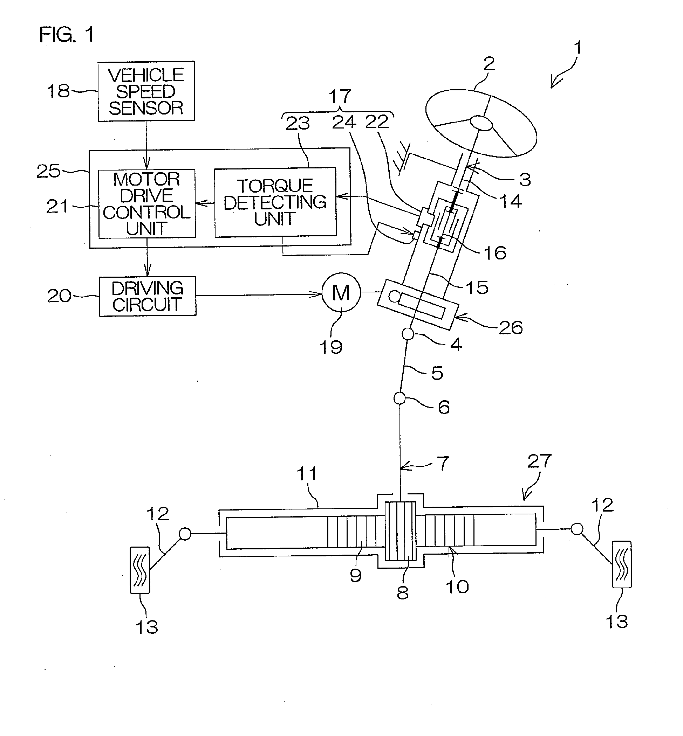

FIG. 1 is a schematic view showing a general structure of an electric power steering system that includes a torque detector according to a first embodiment of the present invention. Referring to FIG. 1, the electric power steering system 1 includes a steering shaft 3 connected to a steering member 2, such as a steering wheel, an intermediate shaft 5 connected to the steering shaft 3 via a universal joint 4, a pinion shaft 7 connected to the intermediate shaft 5 via a universal joint 6, and a rack shaft 10 that forms a rack 9 meshing with a pinion 8 disposed at a forward end of the pinion shaft 7 and that extends in the rightward/leftward direction of a vehicle.

The rack shaft 10 is supported by a cylindrical housing 11 so as to be movable in an axial direction. Tie rods 12 are respectively connected to both ends of the rack shaft 10, and are connected to corresponding steerable wheels 13 via corresponding knuckle arms (not shown), respectively.

When the steering member 2 is operated, the steering shaft 3 is rotated, and the resulting rotation is transmitted to the pinion 8 via the intermediate shaft 5, etc., and is converted by the pinion 8 and the rack 9 into a rectilinear motion of the rack shaft 10 along the rightward/leftward direction of the vehicle. As a result, the steerable wheels 13 are steered.

The steering shaft 3 includes a first steering shaft 14 serving as a first shaft that extends toward the steering member 2 and a second steering shaft 15 serving as a second shaft that extends toward the universal joint 4. The first and second steering shafts 14 and 15 are coaxially connected to each other via a torsion bar 16 serving as a connecting shaft. The first and second steering shafts 14 and 15 can perform torque transmission to each other, and can be relatively rotated within a predetermined range.

The electric power steering system 1 includes a torque detector 17 that detects steering torque applied to the steering member 2, a vehicle speed sensor 18 that detects a vehicle speed, an electric motor 19 used as a steering auxiliary and a motor drive control unit 21 that controllably drives the electric motor 19 via a driving circuit 20 based on a detection result of the torque detector 17 and based on a detection result of the vehicle speed sensor 18.

The torque detector 17 includes a sensor unit 22 disposed near the torsion bar 16, a torque detecting unit 23 that detects steering torque based on a signal from the sensor unit 22, and a magnetic field generator 24 disposed near the sensor unit 22. The motor drive control unit 21 and the torque detecting unit 23 are disposed in an ECU (Electronic Control Unit) 25 including a microcomputer.

In the torque detector 17, torque given to the first and second steering shafts 14 and 15 is detected from a change in magnetic flux based on the amount of relative rotational displacement between the first steering shaft 14 and the second steering shaft 15 resulting from the torsion of the torsion bar 16.

When the motor drive control unit 21 of the ECU 25 drives the electric motor 19 used as a steering auxiliary, its output rotation (power) is decelerated by a speed reduction mechanism 26, such as a worm gear mechanism, and is transmitted to the second steering shaft 15. The power transmitted to the second steering shaft 15 is further transmitted to a steerable mechanism 27 including the rack shaft 10, the tie rod 12, and the knuckle arm, etc., via the intermediate shaft 5, etc. , and, as a result, a steering operation performed by a driver is assisted.

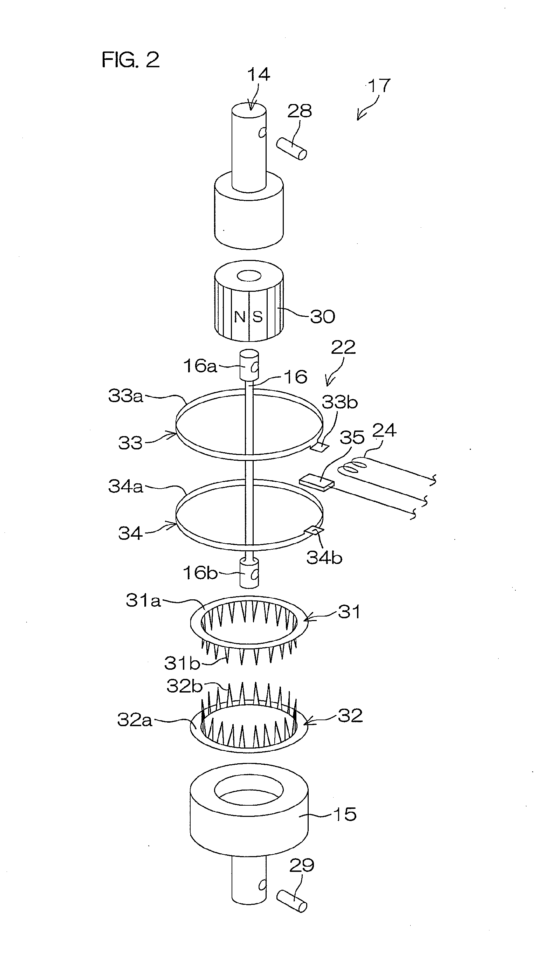

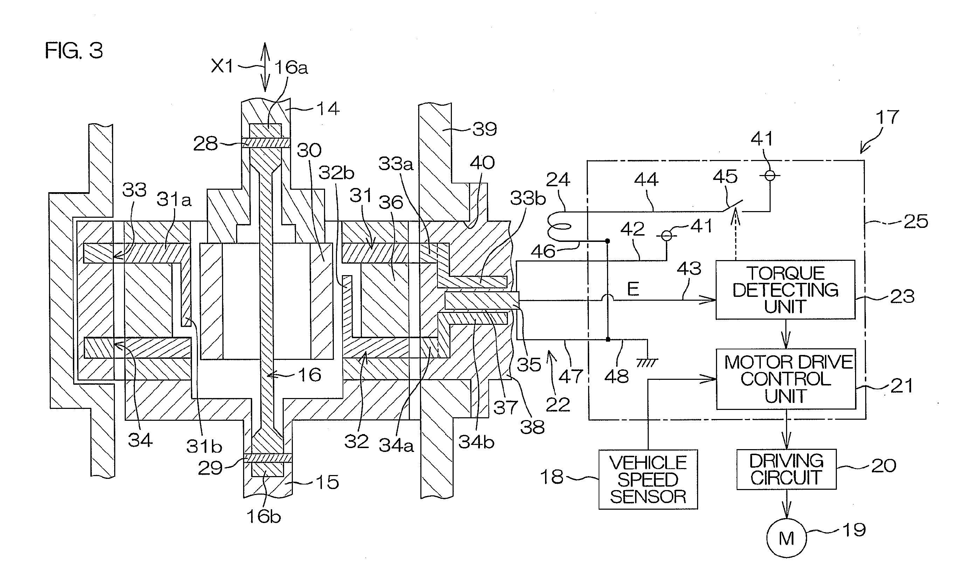

FIG. 2 is a schematic exploded perspective view of a main part of the torque detector 17, and FIG. 3 is a schematic sectional view of a torque transmitting device. As shown in FIG. 2 and FIG. 3, one end 16a of the torsion bar 16 is joined to the first steering shaft 14 by use of a pin 28, and the other end 16b of the torsion bar 16 is joined to the second steering shaft 15 by use of a pin 29.

The torque detector 17 includes a multipolar magnet 30, a pair of magnetic yokes 31 and 32 made of a soft magnetic substance, a pair of magnetic flux collecting rings 33 and 34 that induce a magnetic flux from the magnetic yokes 31 and 32, respectively, a Hall IC 35 that is the only element serving as a magnetic sensor, and the magnetic field generator 24. The magnetic field generator 24 is formed of, for example, a magnetic-field generating coil that can generate a magnetic field in an area including the Hall IC 35.

The multipolar magnet 30 is a multipolar magnetic ring joined to one end of the first steering shaft 14 rotatably together with the first steering shaft 14. N poles and S poles are alternately magnetized at a plurality of positions in the circumferential direction of the ring, respectively. The axis line of the multipolar magnet 30 and the axis line of the first steering shaft 14 coincide with each other.

The pair of magnetic yokes 31 and 32 are joined to one end of the second steering shaft 15 rotatably around the multipolar magnet 30. The pair of magnetic yokes 31 and 32 have yoke rings 31a and 32a that face each other with a distance therebetween and claws 31b and 32b arranged at a plurality of positions in the circumferential direction of the yoke rings 31a and 32a. The pair of magnetic yokes 31 and 32 are molded in a synthetic resin member as shown in FIG. 3 in a state in which the claws 31b and 32b face each other in such a manner as to deviate from each other with appropriate gaps in the circumferential direction. The inner circumferential surface of each of the magnetic yokes 31 and 32, which faces the multipolar magnet 30, is exposed from the synthetic resin member 36.

The synthetic resin member 36 holding the magnetic yokes 31 and 32 is attached to the second steering shaft 15, and is structured so that a magnetic flux density between the yoke rings 31a and 32a is changed by allowing the multipolar magnet 30 and the magnetic yokes 31 and 32 to rotate relatively.

The magnetic yokes 31 and 32 are disposed such that the forward end of each of the claws 31b and 32b thereof is pointed toward the boundary between an N pole and an S pole of the multipolar magnet 30 in a steering neutral state in which torque is not applied to the first and second steering shafts 14 and 15.

The pair of magnetic flux collecting rings 33 and 34 are annular members each of which is made of a soft magnetic substance. The pair of magnetic flux collecting rings 33 and 34 are disposed relatively rotatably around the magnetic yokes 31 and 32, and are magnetically joined to the magnetic yokes 31 and 32, respectively. The pair of magnetic flux collecting rings 33 and 34 includes annular ring bodies 33a and 34a that face each other with a distance therebetween in the axial direction X1 of the first steering shaft 14 and flat flux-collecting pieces 33b and 34b that are projected from the ring bodies 33a and 34a, respectively, and that face each other at their positions located in a single circumferential direction. A Hall IC 35 is inserted in an area 37 between the flux collecting pieces 33b and 34b. This area 37 is filled with a part of the synthetic resin member 38 (described later), and the Hall IC 35 is molded within the synthetic resin member 38.

The pair of magnetic flux collecting rings 33 and 34, the Hall IC, a circuit board (not shown), etc., are molded within the synthetic resin member 38. The synthetic resin member 38 is attached to a cylindrical sensor housing 39 through a mounting hole 40 of the sensor housing 39 in a state in which the magnetic flux collecting rings 33 and 34 are coaxial with the sensor housing 39.

The Hall IC 35 detects the density of a magnetic flux generated in the area 37 between the flux collecting pieces 33b and 34b. The Hall IC 35 is disposed so as to generate an output value (i.e., a potential difference) corresponding to a component parallel to the axial direction X1 of the magnetic flux generated in the area 37. The Hall IC 35 is supplied with electric power from a power source 41, such as a vehicle battery, via a power supply line 42. An output signal (i.e., a voltage signal) E of the Hall IC 35 is output to the torque detecting unit 23 disposed in the ECU 25 via an output line 43.

The torque detecting unit 23 is structured to calculate steering torque input to the steering shaft 3 and to detect a failure of the Hall IC 35 based on a signal level of the output signal E from the Hall IC 35, i.e., based on an output voltage of each Hall IC 35.

The magnetic field generator 24 formed of a magnetic-field generating coil is supplied with electric power from the power source 41 via a power supply line 44. The power supply line 44 is provided with a switch 45 that turns on/off the power supply to the magnetic field generator 24. A ground line 46 of the magnetic field generator 24 and a ground line 47 of the Hall IC 35 are connected to a common ground line 48, and a part of their respective power supply circuits is shared with each other, and yet these circuits may be independent of each other.

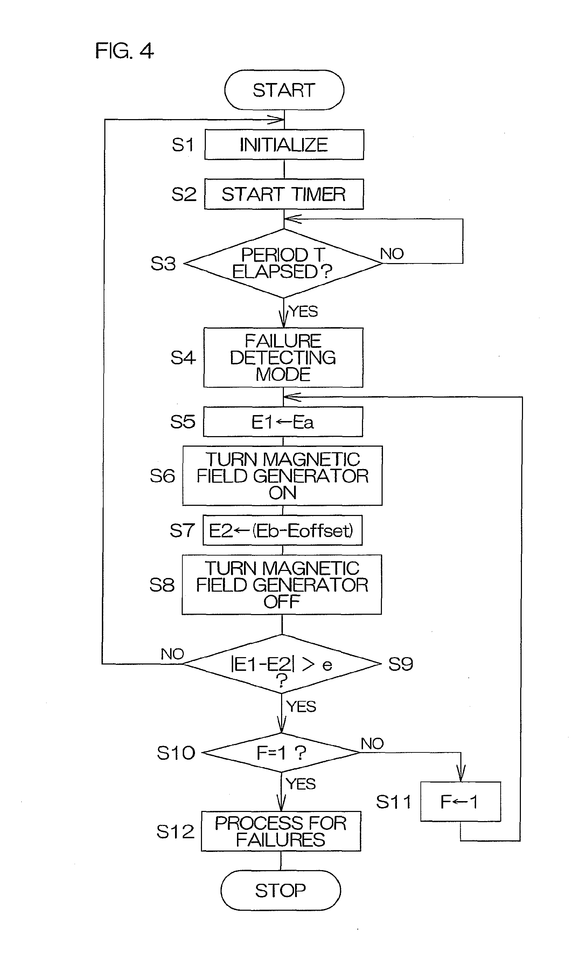

Next, a description will be given of a process of detecting a failure of the sensor unit 22 with reference to the flowchart of FIG. 4.

First, initialization is performed, and a failure detection flag F is set to be 0 (zero) at step S1. Thereafter, a timer is started to perform a failure detecting mode (steps subsequent to step S4) with a predetermined period T at step S2. When the predetermined period T elapses from the start of the timer (step S3), a shift is performed to the failure detecting mode subsequent to step S4.

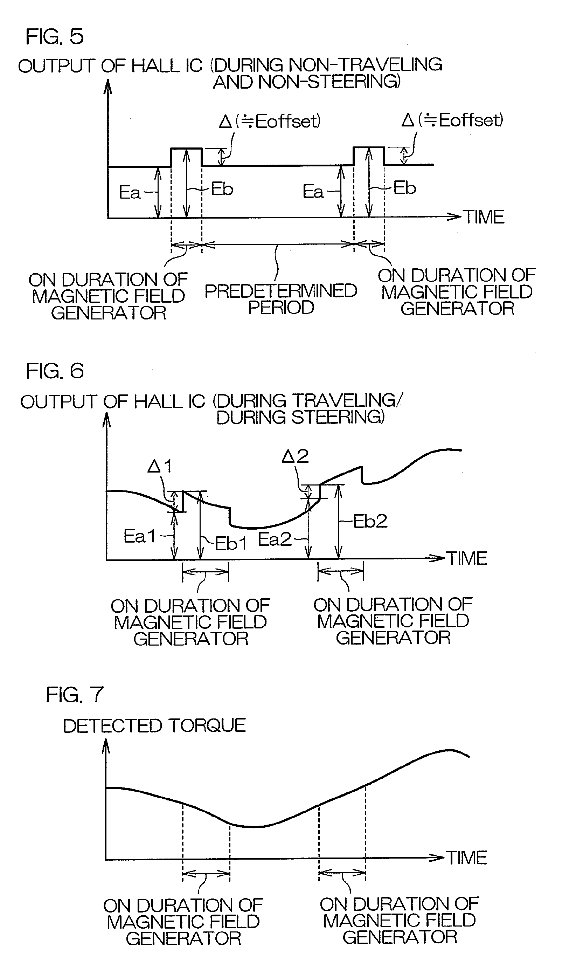

In the failure detecting mode, first, a signal sent from the Hall IC 35 is taken, and its output value Ea is stored as a first value E1 that is a hold value at step S5 (also see FIG. 5).

Thereafter, electric power is supplied to the magnetic field generator 24 by turning on the switch 45 during only a predetermined time (for example, during several microseconds), and the magnetic field is generated in the area including the Hall IC 35 at step S6. Thereafter, by subtracting a predetermined offset amount Eoffset from an output value Eb of the Hall IC 35 during generating the magnetic field, a second value E2 (E2=Eb - Eoffset) is calculated (step S7). The predetermined offset amount Eoffset is fixed by beforehand calculating an amount of change in output voltage of the normal Hall IC 35 caused by the generation of a magnetic field of the magnetic field generator 24.

Thereafter, at step S8, the switch 45 is turned off, and the magnetic field generator 24 is turned off, and the process proceeds to step S9. At step S9, it is determined whether the absolute value |E1-E2| of a difference between the first value E1 and the second value E2 exceeds the range of a predetermined tolerance "e" (|E1-E2|>e). If the absolute value of the difference falls within the range of the tolerance e (i.e., if NO at step S9), it is determined that the sensor unit 22 is normally working, and then the process returns to step S1.

If the absolute value of the difference exceeds the range of the tolerance e (i.e., if YES at step S9), it is confirmed that the failure detection flag F is not 1 (i.e., F is 0, and this is first failure detection) at step S10. If it is confirmed that the failure detection flag F is not 1, i.e., if it is confirmed that this is first failure detection, the failure detection flag F is set to be 1 at step S11, and then the process returns to step S5, and a failure detection flow ranging from step S5 to step S9 is repeatedly performed again.

When a second failure detection flow is performed, if the absolute value of the difference exceeds the range of the tolerance e and if a failure is also detected by the second performance at step S9, it is confirmed that F=1 (i.e., this is a second failure detection) at step S10 subsequent thereto, and then it is determined that the sensor unit 22 is in failure, and a well-known process for failures is performed at step S12. For example, a process in which a driver (a person) is informed of the occurrence of the failure by lighting a warning lamp or a process in which the electric power steering system 1 is safely stopped is performed as the well-known process for failures, and then the process is ended.

On the other hand, if the absolute value of the difference falls within the range of the tolerance e and if the failure is not detected when the second failure detection flow is performed at step S5 to step S9, it is determined at step S9 that the sensor unit 22 is normal, and the process returns to step S1.

FIG. 5 shows, when the vehicle is being stopped and is not steered (i.e., during non-traveling and non-steering), a change in output of the Hall IC 35 caused when the failure detecting mode is performed with a predetermined period. The output of the Hall IC 35 is changed by an amount of change Δ in response to the turn-on of the magnetic field generator 24, and, if the Hall IC 35 is normal, the amount of change Δ is substantially equal to a predetermined offset amount Eoffset.

Next, FIG. 6 shows the change in output of the Hall IC 35 caused when the failure detecting mode is performed with a predetermined period under at least one of two conditions, i.e., the condition that the vehicle is traveling and the condition that the vehicle is steered. In response to the turn-on of the magnetic field generator 24, the output of the Hall IC is changed by an amount of change Δ1 (which corresponds to a difference between an output value Ea1 obtained before the magnetic field is generated and an output value Eb1 obtained when the magnetic field is generated) or an amount of change Δ2 (which corresponds to a difference between an output value Ea2 obtained before the magnetic field is generated and an output value Eb2 obtained when the magnetic field is generated). If the Hall IC 35 is normal, the amount of change Δ1 and the amount of change Δ2 become substantially equal to the predetermined offset amount Eoffset.

On the other hand, before and after the generation of the magnetic field, torque detection that uses the output of the Hall IC 35 of FIG. 6 may be performed by use of the first value E1 as a hold value or by use of the second value E2 obtained when the magnetic field generator 24 is turned on. The second value E2 is calculated by subtracting the offset amount Eoffset from the output of the Hall IC 35 obtained when the magnetic field generator 24 is turned on (in other words, an amount of influence received by the generation of the magnetic field is canceled). Therefore, if the sensor unit 22 is normal, the second value E2 can be dealt with in the same manner as the output of the sensor obtained when the magnetic field generator 24 is in an off state. Additionally, the time during which the magnetic field generator 24 is in an on state is extremely short, such as several microseconds, and therefore the amount of torque changed by the steering operation performed by the person for this time duration is considered to be extremely small.

Therefore, detected torque calculated from the first and second values E1 and E2 each of which serves as the hold value becomes smooth as shown in FIG. 7, and therefore steering torque detected based on either of the first and second values E1 and E2 can be used to controllably drive the electric motor 19.

According to this embodiment, the torque detector 17 having the simple structure using the single Hall IC 35 serving as the magnetic sensor can make its production costs low. Additionally, based on the offset amount of the output of the sensor unit 22 obtained when the magnetic field is generated by the magnetic field generator 24, the failure of the sensor unit 22 (specifically, the failure of the Hall IC 35 or the failure of the output line 43 connected to the Hall IC) can be detected, and reliability can be heightened. Still additionally, the electric power steering system 1 that is a low-cost system and that has high reliability can be realized.

According to this embodiment, abnormality of the sensor unit 22 is detected based on the absolute value |E1-E2| of the difference between the first value E1 that holds the output value Ea of the sensor unit 22 obtained immediately before the generation of the magnetic field and the second value E2 obtained by subtracting the predetermined offset amount Eoffset from the output value Eb of the sensor unit 22 obtained when the magnetic field is generated.

If the sensor unit 22 is normal, the torque detecting unit 23 detects steering torque by use of the first value E1 and the second value E2 serving as the hold value, and the electric motor 19 can be controllably driven by use of the detected steering torque and the vehicle speed detection result of the vehicle speed sensor 18.

In other words, the second value E2 is calculated by subtracting the offset amount Eoffset from the output of the Hall IC 35 obtained when the magnetic field is generated (i.e., the amount of influence received by the generation of the magnetic field is canceled), and therefore, if the sensor unit 22 is normal, torque can be detected while dealing with the second value E2 in the same manner as the output of the sensor obtained when the magnetic field generator 24 is in the off state.

As described above, smoothness in control continuity can be improved by use of either of the first value E1 and the second value E2, and a bad influence is never exerted on the driving and control of the electric motor 19, and therefore the failure can be substantially detected even while the vehicle is traveling or the electric power steering system 1 is being controlled.

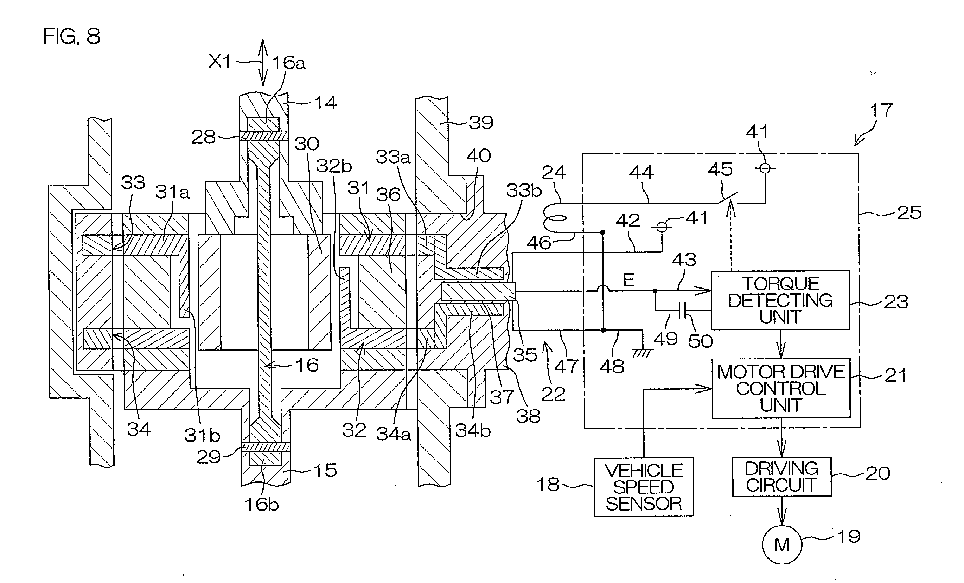

Next, FIG. 8 shows a second embodiment of the present invention. This embodiment differs from the embodiment of FIG. 3 in the fact that a pair of output lines 43 and 49 are provided to double the output from the sensor unit 22 and in the fact that a capacitor 50 is interposed between the torque detecting unit 23 and the output line 49 that is one of the pair of output lines used for failure detection. The capacitor 50 outputs a differential value of the output of the Hall IC 35. In this case, an unusual, rapid change of detected torque can be taken out based on the differential output via the capacitor 50.

In this embodiment, the frequency with which the failure detecting mode is performed by the torque detecting unit 23 is set based on a change in the differential value of the output of the Hall IC 35 via the capacitor 50. For that, a period T (see step S3 of FIG. 4) with which the failure detecting mode is performed is set.

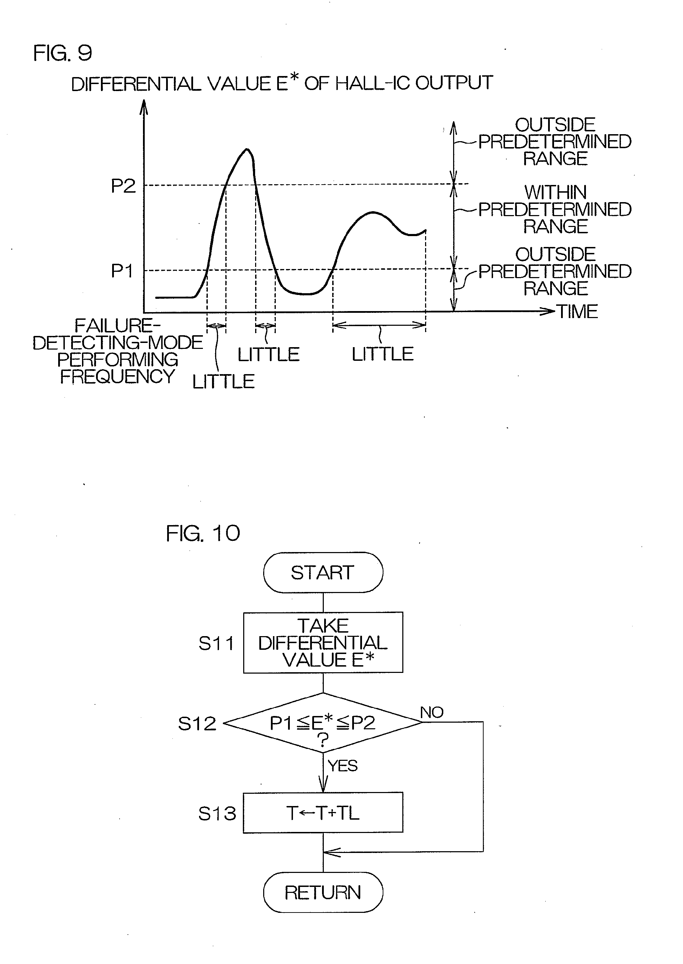

More specifically, let it be supposed that the differential value E* of the output E of the Hall IC 35 is changed as shown in FIG. 9. A value P2 is a value having a rate of change that is a little lower than a high rate of change that cannot be caused by the steering wheel control performed by the driver in FIG. 9. The range less than a value P1 is a range that corresponds to that of a period during which the vehicle is not steered.

As shown in the flowchart of FIG. 10, it is determined at step S12 whether the differential value E* read at step S11 (which corresponds to the rate of change of the output of the sensor unit 22) falls within a predetermined range (specifically, whether the relation P1≤E*≤P2 is satisfied).

If the differential value E* falls within the predetermined range (i.e., if the relation P1≤E*≤P2 is satisfied and if YES at step S12), a period (T+TL) that is longer than a period obtained by adding an addition value TL to the normal period T is employed (step S13). Herein, the addition value TL may be infinite. Namely, the failure detecting mode is performed every first frequency.

If the differential value E* does not fall within the predetermined range, (specifically, if either one of the relation E*<P1 and the relation P2<E* is satisfied and if NO at step S12), the normal period T is employed. Namely, the failure detecting mode is performed every second frequency.

As a result, the first frequency with which the failure detecting mode is performed when the differential value E* of the output of the Hall IC 35 (which corresponds to the rate of change of the output of the sensor unit) falls within a predetermined range (i.e., when the relation P1≤E*≤P2 is satisfied) is set to be lower than the second frequency with which the failure detecting mode is performed when the differential value E* does not fall within the predetermined range, (i.e., when either one of the relation E*<P1 and the relation P2<E* is satisfied). In other words, when the sensor unit is considered to be normal, the number of times (i.e., frequency) when failure detection is performed is made low. As a result, a control load imposed on the ECU 25 is reduced. On the other hand, when the rate of change of the output of the sensor unit 22 is a high rate of change that cannot be caused by the steering wheel control performed by the driver or is a rate of change close to such a high rate of change, reliability can be improved by relatively heightening the frequency with which the failure detecting mode is performed.

A third embodiment is characterized in that the period T with which the failure detecting mode is performed is set based on steering torque detected in the first and second embodiments.

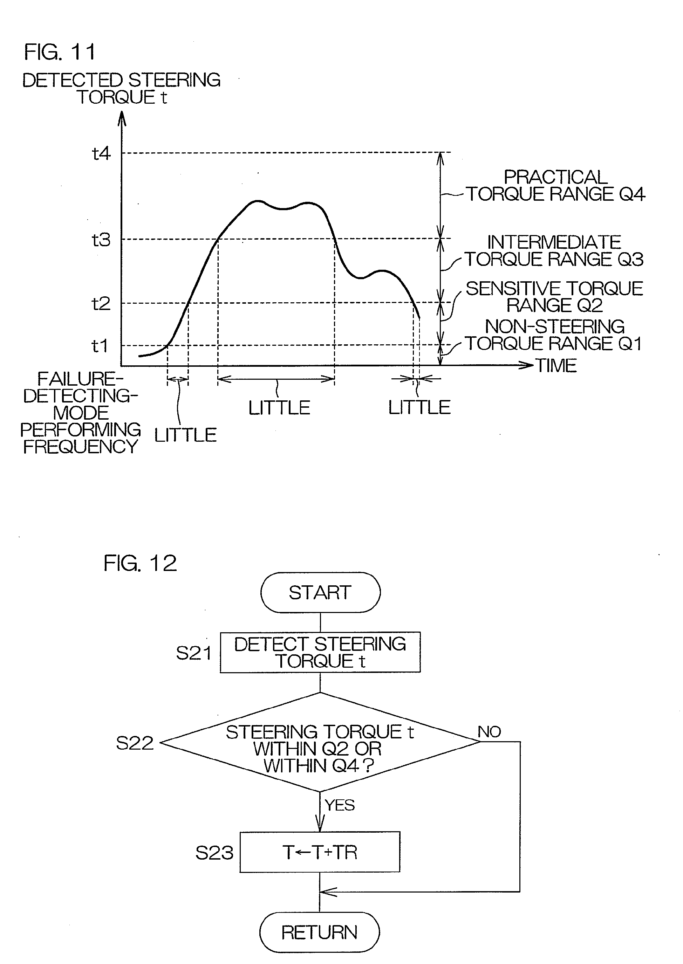

More specifically, let it be supposed that steering torque t detected based on the output from the Hall IC 35 is changed as shown in FIG. 11. In this embodiment, the following ranges of steering torque are set, i.e., a non-steering torque range Q1 (t<t1) that is a first torque range, a sensitive steering torque range Q2 (t1<t<t2) that is a second torque range, an intermediate torque range Q3 (t2<t<t3) that is a third torque range, and a practical torque range Q4 (t3<t<t4) that is a fourth torque range are set in this order in proportion to an increase in steering torque from 0.

The sensitive torque range Q2 is a range of torque detected, for example, when a driver performs correction steering little by little while the vehicle is traveling on an expressway. The practical torque range Q4 is a range of torque detected, for example, when the vehicle turns to the left or right at an intersection or when the vehicle goes out of a parking space while turning to the left or right, and is a most-frequently-used range of torque.

On the other hand, the intermediate torque range Q3 between the sensitive torque range Q2 and the practical torque range Q4 is a range of torque detected, for example, when the steering wheel begins to be turned or when the steering wheel is returned while slipping the handle in the driver's hands.

In this embodiment, at step S22, it is determined whether steering torque t read at step S21 falls within either one of the sensitive torque range Q2 and the practical torque range Q4 as shown in the flowchart of FIG. 12. If steering torque t falls within either one of the sensitive torque range Q2 and the practical torque range Q4 (if YES at step S22), a period (T+TR) that is longer than a period obtained by adding an addition value TR to the normal period T is employed (step S23). Namely, the failure detecting mode is performed every third frequency. Herein, the addition value TRmay be infinite.

On the other hand, if steering torque t does not fall within either one of the sensitive torque range Q2 and the practical torque range Q4 (if NO at step S22), i.e., if steering torque t falls within the non-steering torque range Q1 or within the intermediate torque range Q3, the normal period T is employed. Namely, the failure detecting mode is performed every fourth frequency.

According to this embodiment, in the sensitive torque range Q2 and the practical torque range Q4, which are usually frequently-used torque ranges, the third frequency with which the failure detecting mode is performed is made relatively low, and therefore a control load imposed on the ECU 25 can be reduced, and an excellent steering feeling can be secured in these torque ranges Q2 and Q4.

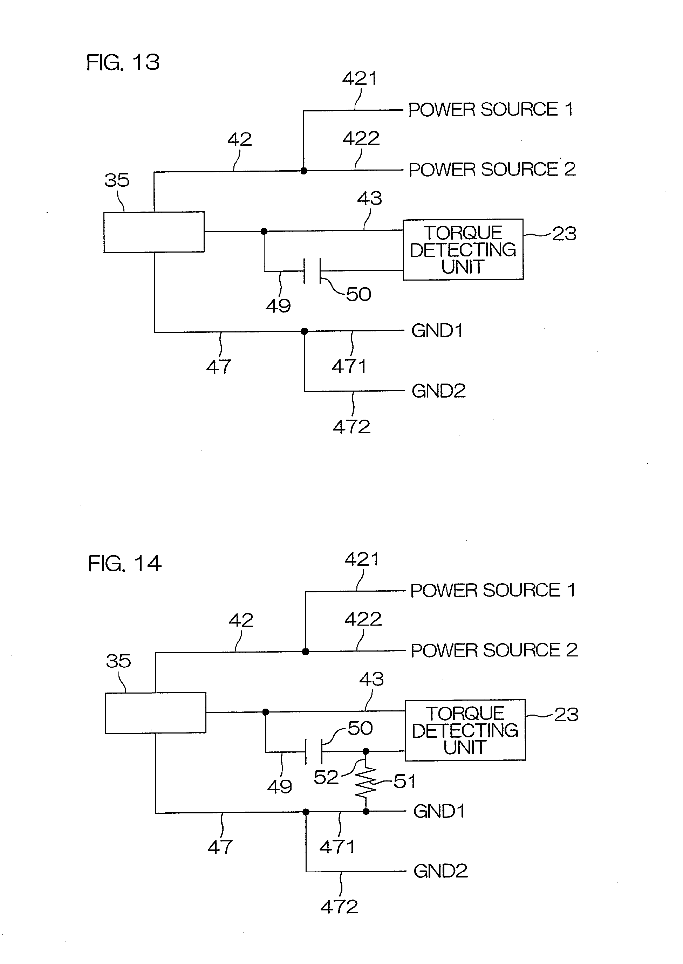

The present invention is not limited to the above-mentioned embodiments, and a fail-safe performance may be improved by doubling at least a part of the power supply line 42 to the Hall IC 35 in the form of lines 421 and 422 or by doubling at least a part of the ground line 47 from the Hall IC 35 in the form of lines 471 and 472 as shown in, for example, FIG. 13.

Additionally, a middle part of the output line 43 of the Hall IC 35 in the embodiment of FIG. 3 or a middle part of the output line 49 of the Hall IC 35 in the embodiment of FIG. 8 or in the embodiment of FIG. 13 may be connected to a ground line 471 via a connection line 52 having a pull-down resistance 51 as shown in, for example, FIG. 14. In this case, when the output of the Hall IC 35 reaches an unfixed state that is neither abnormal nor normal (i.e., a state in which an unfixed signal irrelevant to steering torque is output although it falls within a normal range), its output signal can be pulled down into 0 V, and therefore the reliability of failure detection can be improved.

Additionally, a magnetoresistance element (MR element) may be used as a magnetic sensor instead of the Hall IC.

Although the present invention has been described in detail according to the specific aspects as above, persons skilled in the art who have understood the above-mentioned contents will easily think of modifications, improvements, and equivalents thereof. Therefore, the present invention should be within the scope and equivalence of the appended claims.

This application is based on Japanese Patent Application No. 2010-70203, filed in Japan Patent Office on March 25, 2010, the entire contents of which are hereby incorporated by reference.
A torque detector (17) includes a sensor unit (22) including a single magnetic sensor (35) capable of detecting a change of flux, a torque detecting unit (23) that detects torque based on an output of the sensor unit (22), and a magnetic field generator (24) capable of generating a magnetic field in an area including the sensor unit (22). The torque detecting unit (23) has a failure detecting mode that detects an abnormality of the sensor unit (22) based on an offset amount of the output of the sensor unit (22). The offset amount is obtained when the magnetic field is generated by the magnetic field generator (24).

## Claims

1. A torque detector (17) comprising:
a sensor unit (22) including a single magnetic sensor (35) capable of detecting a change of flux; and
a torque detecting unit (23) that detects torque based on an output value of the sensor unit (22);
**characterized by** a magnetic field generator (24) capable of generating a magnetic field in an area including the sensor unit (22),
wherein the torque detecting unit (23) has a failure detecting mode that detects an abnormality of the sensor unit (22) based on an offset amount (Eoffset) of the output value of the sensor unit (22), and
the offset amount (Eoffset) is obtained when the magnetic field is generated by the magnetic field generator (24).

2. The torque detector (17) according to claim 1, **characterized by** further comprising:
a pair of output lines (43, 49) that double an output from the sensor unit (22); and
a capacitor (50) interposed between either one of the pair of output lines (43,49) and the torque detecting unit (23).

3. The torque detector (17) according to claims 1 or 2, **characterized in that**
in the failure detecting mode, the abnormality of the sensor unit (22) is detected if an absolute value (|E1-E2|) of a difference between a first value (E1) and a second value (E2) exceeds a predetermined amount, **in that**
the first value (E1) holds the output value (Ea) of the sensor unit (22) immediately before the magnetic field is generated, and **in that**
the second value (E2) is obtained by subtracting the offset amount (Eoffset) from the output value (Eb) of the sensor unit (22) when the magnetic field is generated.

4. The torque detector (17) according to any one of claims 1 to 3, **characterized in that**
the torque detecting unit (23) makes a first frequency (including zero) with which the failure detecting mode is performed when a rate of change (E*) of the output value of the sensor unit (22) falls within a predetermined range (P1≤E*≤P2) lower than a second frequency with which the failure detecting mode is performed when the rate of change does not fall within the predetermined range (P1≤E*≤P2).

5. The torque detector (17) according to any one of claims 1 to 4, **characterized in that**
the torque detecting unit (23) sets a first torque range (Q1), a second torque range (Q2), a third torque range (Q3), and a fourth torque range (Q4) as a range of the torque (t) in proportion to an increase in the torque (t), and **in that**
a third frequency with which the failure detecting mode is performed in the second torque range (Q2) and in the fourth torque range (Q4) is made lower than a fourth frequency with which the failure detectingmode is performed in the first torque range (Q1) and in the third torque range (Q3).

6. An electric power steering system (1) comprising:
a torque detector (17); and
a motor drive control unit (21) that controllably drives an electric motor (19) based on steering torque (t) detected by the torque detector (17),
the torque detector (17) comprising:
a sensor unit (22) including a single magnetic sensor (35) capable of detecting a change of flux; and
a torque detecting unit (23) that detects torque based on an output value of the sensor unit (22);
**characterized by** a magnetic field generator (24) capable of generating a magnetic field in an area including the sensor unit (22),
wherein the torque detecting unit (23) has a failure detecting mode that detects an abnormality of the sensor unit (22) based on an offset amount (Eoffset) of the output value of the sensor unit (22), and
the offset amount (Eoffset) is obtained when the magnetic field is generated by the magnetic field generator (24).

7. The electric power steering system (1) according to claim 6 wherein the torque detector (17) comprises:
a pair of output lines (43,49) that double an output from the sensor unit (22); and
a capacitor (50) interposed between either one of the pair of output lines (43,49) and the torque detecting unit (23).

8. The electric power steering system (1) according to claims 6 or 7 **characterized in that**
in the failure detecting mode, the abnormality of the sensor unit (22) is detected if an absolute value (|E1-E2|) of a difference between a first value (E1) and a second value (E2) exceeds a predetermined amount, **in that**
the first value (E1) holds the output value (Ea) of the sensor unit (22) immediately before the magnetic field is generated, and **in that**
the second value (E2) is obtained by subtracting the offset amount (Eoffset) from the output value (Eb) of the sensor unit (22) when the magnetic field is generated.

9. The electric power steering system (1) according to claim 8, **characterized in that**
the motor drive control unit (21) controllably drives the electric motor (19) based on either one of the first value (E1) and the second value (E2).

10. The electric power steering system (1) according to any one of claims 6 to 9, **characterized in that**
the torque detecting unit (23) makes a first frequency (including zero) with which the failure detecting mode is performed when a rate of change (E*) of the output value of the sensor unit (22) falls within a predetermined range (P1≤E*≤P2) lower than a second frequency with which the failure detecting mode is performed when the rate of change does not fall within the predetermined range (P1≤E*≤P2).

11. The electric power steering system (1) according to claims 6 to 10 **characterized in that**
the torque detecting unit (23) sets a first torque range (Q1), a second torque range (Q2), a third torque range (Q3), and a fourth torque range (Q4) as a range of the steering torque (t) in proportion to an increase in the steering torque (t), and **in that**
a third frequency with which the failure detecting mode is performed in the second torque range (Q2) and in the fourth torque range (Q4) is made lower than a fourth frequency with which the failure detectingmode is performed in the first torque range (Q1) and in the third torque range (Q3).
